# EUROPEAN PATENT APPLICATION

(11) **EP 1 063 584 A1**
(43) Date of publication of application: **27.12.2000**
(21) Application number: 98967086.4
(22) Date of filing: 25.12.1998
(51) Int. Cl.: G06F 7/58

(54) **CODE GENERATOR**

(71) Applicant: Samsung Electronics Co., Ltd., Suwon-city, Gyungki-do (KR)
(72) Inventor: ROG, Andrei Leonidovich, Moscow, 107143 (RU); IVANOV, Vladimir Nikolaevich, St.Petersburg, 195297 (RU); SOSHIN, Mikhail Petrovich, St.Petersburg, 194295 (RU); MALASHIN, Viktor Ivanovich, St.Petersburg, 195273 (RU); POVERENNYI, Denis Georgievich, St.Petersburg, 195297 (RU); SHEBSHAEVICH, Boris Valentinovich, St.Petersburg, 190121 (RU); SILIN, Mikhail Jurievich, Moscow, 105094 (RU); FEDOTOV, Boris Dmitrievich, St.Petersburg, 195213 (RU)
(74) Representative: Neill, Alastair William
(86) International application number: RU9800434
(87) International publication number: WO0039667

(57) **Abstract**

The invention relates to the field of radio navigation and, particularly, to pseudo-random (PRS) code-sequence generators to be used as reference code generators of the digital correlation processing of signals in multichannel receivers of pseudonoise signals of the satellite radio navigation systems (SRNS) GPS and GLONASS. The technical task to be achieved by the claimed invention is creation of a PRS SRNS code generator providing a possibility of operation in two modes: in the mode of shaping the PRS code of the GPS system and in the mode of shaping the PRS code of the GLONASS system, in which case the common elements of the generator take part in shaping both these codes, thus allowing one to simplify the design and to reduce the number of elements of the used equipment. The result is achieved due to optimization of the connection and interaction of the standard elements of the generator.

## Description

### Technical field

The invention relates to the field of radio navigation and, more specifically, it relates to pseudo-random code-sequence (PRS) generators, intended for use as reference-code generators during digital correlation processing of signals in multichannel receivers of pseudonoise (noise-like) signals of satellite radio navigation systems (SRNS) GPS (USA) and GLONASS (Russia) operating with the signals of the C/A codes of these systems in the LI frequency range.

### Prior engineering level

Known in the art are receivers of pseudonoise (noise-like) signals of the SRNS GLONASS system ("Global Navigation Satellite System - GLONASS. The interface control document. KNITS VKS Russia", 1995) [1] and GPS ("Global Position System. Standard Positioning Service. Signal Specification" USA, 1993) [2], which are used for radio navigation measurement of the coordinates (latitude, longitude, height) and velocity of objects, as well as time. In so doing the received signals of the space navigation apparatus - SRNS satellites are converted by frequency, demodulated and subjected to digital correlation processing in which the codes of the signals of the SRNS satellites are compared to the reference PRS codes generated by the corresponding generators. The fundamental distinctions between the signals of the SRNS GPS and GLONASS satellites consist in the use of various, though adjacent, frequencies in the LI range, the use of different pseudonoise modulating codes and the use, respectively, of the code and frequency division of signals of the various satellites in the system. Thus, during the operation in the LI frequency range the SRNS GPS satellites radiate signals modulated by various pseudonoise codes on one carrier frequency of 1575.42 MHz while the SRNS satellites radiate the GLONASS signals modulated by the same code on various carrier (lettered) frequencies laying in the adjacent frequency field. The distinctions existing between SRNS GPS and GLONASS signals stipulated by the code division of the signals in the SRNS GPS and frequency division in the SRNS GLONASS determine the distinctions in the design of the equipment employed for reception and correlation processing of the signals of these SRNS. In so doing, in spite of the distinctions existing between the SRNS GPS and GLONASS, their closeness on the designation, ballistic construction of the orbital grouping of the satellites and the used frequency range allows one to solve the problems associated with the creation of receivers operating with the signals of both systems, that is the integrated SRNS receivers. The result thus achieved consists in high reliability, authenticity and accuracy of fixing the position of the object, mainly due to the possibility of selection of the working constellations of satellites of each SRNS with the best geometrical parameters ("Network Satellite Radio Navigation Systems", V.S. Shebshaevich, P.P. Dmitriev, N.V. Iventsevich et al., Moscow, "Radio i Svyaz", 1993, page 160) [3]. A disadvantage of the above-mentioned technical solutions is that they have a complex design and significant overall dimensions.

In one of the prior-art solutions [1] the PRS code for SRNS GLONASS consists of an M-sequence having a length of 511 characters with a repetition time of 1 ms. The structural properties of the M-sequences, their correlation functions and the spectra are generally discussed, for example, in the book "Theory and Application of Pseudorandom Signals" (A.A. Alekseev, A.G. Shermet'ev, G.I. Tuzov and B.I. Glazov, Moscow, Nauka, 1969, page 85-103) [5], in which there is also presented a general block diagram of the M-sequence generator (cf. page 85-87, Fig. 3.1) [5]. In a general view the M-sequence generator is a shift register whose inputs receive the clock shift signal and feedback signal shaped by a modulo-two adder from the signals of two definite bits of this register. For concrete variants of the application, namely, for the SRNS GLONASS case, the design of the M-sequence generator or the PRS code generator of the GLONASS system is considered, for example, in [1] (cf. page 20-23, fig. 3.2, 3.3). This prior art generator of the PRS code of the GLONASS system comprises a nine-bit shift register whose clock input receives the clock-frequency signal while the data input receives the result of the modulo-two data addition from the fifth and ninth bits of this shift register. The initial (single) value of the bits of the shift register is installed with the help of a device for setting all "1". The outputs of all nine bits of the shift register are connected through a data bus to the detector of all "1", which produces an epoch of one millisecond long. The pulse from the epoch is used to control the PRS code generator in the setting mode and is also used as one of the output signals of the PRS code generator to form the time stamp. The output of the signals of the generated PRS code is the output of the seventh bit of the shift register. The control of the PRS code generator is carried out with the help of a control unit acted on by the external control signals and above-mentioned epoch pulse from the output of the detector of all "1". The control unit produces a signal for resetting the shift register, thereby providing control of the temporary shift of the generated PRS code.

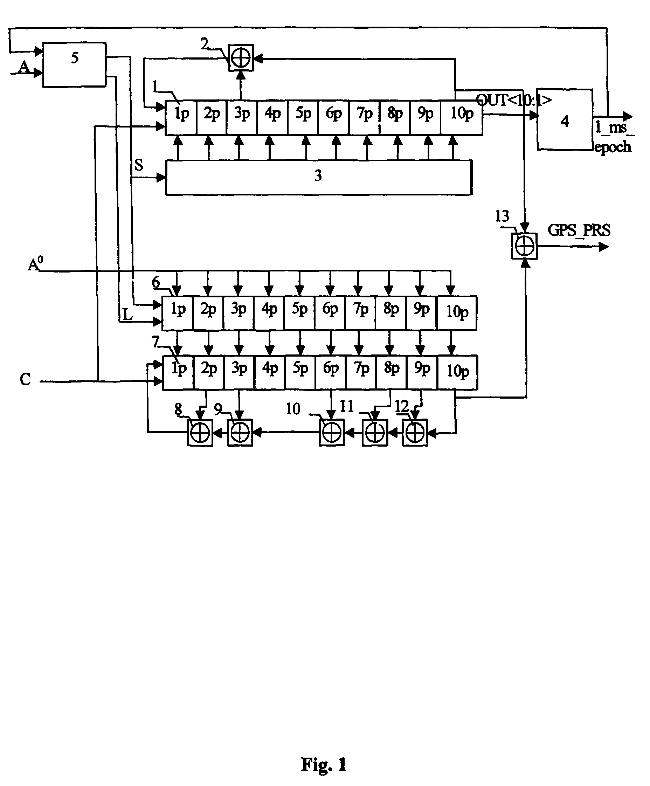

In contrast to the SRNS GLONASS, in the SRNS GPS the PRS code consists of a family of the Gold codes with a length of 1023 characters and with a repetition time of 1 ms [2]. In general aspects, the family of the PRS codes based on the Gold functions are considered, for example, in the "Global Positioning System: Theory and Application" (Edited by Bradford W. Parkinson, James J. Spilker Jr., US, 1995, page 62-80) [6]. The specific example of the design of the PRS code generator for the SRNS GPS based on the Gold functions is presented in the "Minimum Operation Performance Standards For Positioning System / Wide Area Augmentation System Airborne Equipment" (PTCA/DO-229, January 16, 1996. - Appendix A, page 5-8, Fig. A-3) [7]. This PRS code generator having a maximum similar features with the claimed apparatus is selected as a prior art solution. The block diagram of the PRS code generator taken as a prior art is shown in Fig. 1. The PRS code generator selected as a prior art comprises (Fig.1) a ten-bit ("P1", "P2"..., "P10") shift register 1, whose data input is connected to the output of a modulo two adder 2 whose first and second inputs are connected to the outputs of the third and tenth bits of the register 1. The clock input of the register 1 makes up a clock signal input of the PRS code generator, that is an input of the "Code_clk" signals. The inputs of the bit set up of the register 1 are connected to the respective outputs of the device 3 for setting all "1". The outputs of all ten bits of the register 1 through the "Out<10:1>" data bus are connected to the inputs of the detector 4 of all "1" forming at its output a pulse of one millisecond epoch ("1_ms_epoch"). The output of the detector 4 is an output of the epoch signal of the PRS code generator. The output of the detector 4 is connected to the first input of the control unit 5 whose second input is a control input of the PRS code generator that is the input of the "control" signals. The first and second outputs of the control unit 5 ("Set" and "Load" outputs) are connected to the respective inputs of the ten-bit initial-phase register 6. Besides, the first output ("Set" output) of the control unit 5 is connected also to the output of the device 3 for setting up all "1". The inputs of setting the bits of the initial phase register 6 are connected to the input data bus of the PRS code generator, i.e. to the "Initial state" bus- A⁰. The outputs of the bits of the initial phase register 6 are connected to the inputs for setting the respective bits of the ten-bit shift register 7. The clock input of the register 7 is connected to the clock input of the register 1. The data input of the register 7 is connected to the output of the modulo-two adder 8 whose first input is connected to the output of the second bit of the register 7 and the second input is connected to the output of the modulo-two adder 9. The first and second inputs of the adder 9 are connected to the output of the third bit of the register 7 and to the output of the modulo-two adder 10. The first and second inputs of the adder 10 are connected to the output of the sixth bit of the register 7 and to the output of the modulo-two adder 11. The first and second inputs of the adder 11 are connected to the output of the eighth and tenth bits of the register 7 and to the output of the modulo-two adder 12. The first and second inputs of the adder 12 are connected to the outputs of the ninth and tenth bits of the register 7. The outputs of the tenth bits of the shift registers 1 and 7 are connected also to the first and second inputs of the modulo-two adder 13, whose output makes up an output of the PRS code signals of the PRS code generator that is the output of the "GPS_PRS" signals.

The PRS code generator accepted as the prior art operates as follows. The "Code_clk" code at the clock frequency is applied to the input of the ten-bit shift register 1, thereby initiating the data shift in the register, and the modulo-two sum data from the third and tenth bits of the register 1 shaped by the adder 2 is applied to the data input. The initial ("1") value of the bits of the register 1 is set with the help of the device 3, which sets all "1" by means of the "Set" signal produced by the control unit 5. The data of all bits of the register 1 through the data bus ("Out < 10:1 >") are applied to the detector 4 of all "1" which produces a millisecond epoch pulse ("1_ms_epoch") when all "1" at the input coincide. The ("1_ms_epoch") epoch signal is one of the output signals of the PRS code generator intended for shaping the range samples, when performing the radio navigation measurements of the SRNS signals in the SRNS signal receiver. In the PRS code generator the epoch signal ("1_ms_epoch") produced by the detector 4 is used to control the PRS code generator in the setup mode, as well as in the conventional operating mode for reloading the contents of the initial phase register 6 into the ten-bit shift register 7. In so doing the epoch signal ("1_ms_epoch") is applied to the input of the control unit 5 which, depending on the value of the "Control" signal, generates the "Set" signal either at the moment the respective millisecond epoch (tracing mode) or at a preset moment (tuning mode). The control unit 5 also generates a signal "Load" used for recording the data from the "Initial state" bus into the initial phase register 6. The content of the initial phase register 6 determines the number of the generated Gold functions depending on the SRNS GPS satellite. The "Set" signal in the conventional operating mode results in a reload of contents of the initial phase register 6 into the ten-bit shift register 7. The clock frequency of the "Code_clk" code is applied to the input of the shift register 7, while the result of the sequential addition of the modulo-two (by means of adders 12, 11, 10, 9 and 8) data from the tenth, ninth, eighth, sixth, third and second bits of the register 7 are applied to the data inputs of this register. The bit-by-bit shift of the data in the shift registers 1 and 7 is performed simultaneously under the effect of the "Code_clk" clock signals, in which case the signals from the tenth bits of the registers 1 and 7 are summed up by modulo-two in the adder 13 producing an output signal ("GPS_PRS") of the PRS code generator, i.e. the PRS code of the GPS system. Thus, the prior art generator solves the problem of shaping the PRS code of the GPS system providing a possibility of effecting the digital correlation processing of signals of the GPS system in the signal SRNS receiver. However, the prior art generator does not provide a possibility of shaping the PRS code of the GLONASS system. At the same time, known in the art are receivers operating both in the GLONASS and in GPS systems (cf. Riley S., Howard N., Aardom E., Daly P., Siivestrin P. "A Combined GPS/GLONASS High Precision Receiver for Space Applications" (Proc. of ION GPS-95, Palm Springs, CA, US, Sept. 12-15, 1995, page 835-844) [4].

### Disclosure of the invention

The technical problem to be attained by means of the claimed invention is the creation of a PRS SRNS code generator providing a possibility of operation in two modes: in the mode of shaping the PRS code of the GPS system and in the mode of shaping the PRS code of the GLONASS system, the shared elements of the generator being used for shaping both these codes, thereby allowing one to simplify the design and to miniaturize the equipment. One of possible ways of solving this problem consists in maximum usage of the common equipment which can be employed in an integrated receiver for processing the signals of both systems.

The essence of the claimed invention consists in provision of a PRS SRNS code generator comprising a first ten-bit shift register whose clock input is a clock input of the generator, the data input is connected to an output of a first modulo-two adder, the bit setting inputs are connected to the respective outputs of the device for setup all "1", and the bit outputs are connected to the inputs of the detector of all "1" whose output, being an epoch signal output of the generator, is connected to the first input of the control unit whose other input is a first control input of the generator, the first output of the control unit is connected to the input of the device for setting all "1", as well as to the first input of the initial phase ten-bit register whose second input is connected to the second output of the control unit, the bit setting inputs of the initial phase register are connected to the data bus, and the bit outputs are connected to the inputs of the unit for setting the corresponding bits of the second ten-bit shift register whose clock input is connected to the clock input of the first shift register, the data input is connected to the output of the second modulo-two adder and the outputs of the second, third, sixth, eighth and ninth bits are connected, respectively, to the first inputs of the second, third, fourth, fifth and sixth modulo-two adders, the second input of the sixth modulo-two adder being connected to the output of the tenth bit of the second ten-bit shift register; the outputs of the sixth, fifth, fourth and third modulo-two adders are connected, respectively, to the second inputs of the fifth, fourth, third and second modulo-two adders, the outputs of the tenth bits of the first and second shift registers being connected to the inputs of the seventh modulo-two adder; introduced into the system are first, second, third and fourth switches whose control inputs are interconnected and make up a second control input of the generator; the output of the tenth bit of the first shift register is connected to the corresponding input of the all "1" detector through the first switch whose second signal input is an input of a logical item signal; the outputs of the third and fifth bits of the first shift register are connected, respectively, to the first and second signal inputs of the second switch; the outputs of the tenth and ninth bits of the first shift register are connected, respectively, to the first and second signal inputs of the third, switch, the outputs of the second and third switches being connected to the inputs of the first modulo-two adder; the output of the seventh modulo-two adder and the output of the seventh bit of the first shift register are connected, respectively, to the first and second signal inputs of the fourth switch, whose output is an output of the code signals of the pseudo-random sequence of the generator.

### The description of the drawings

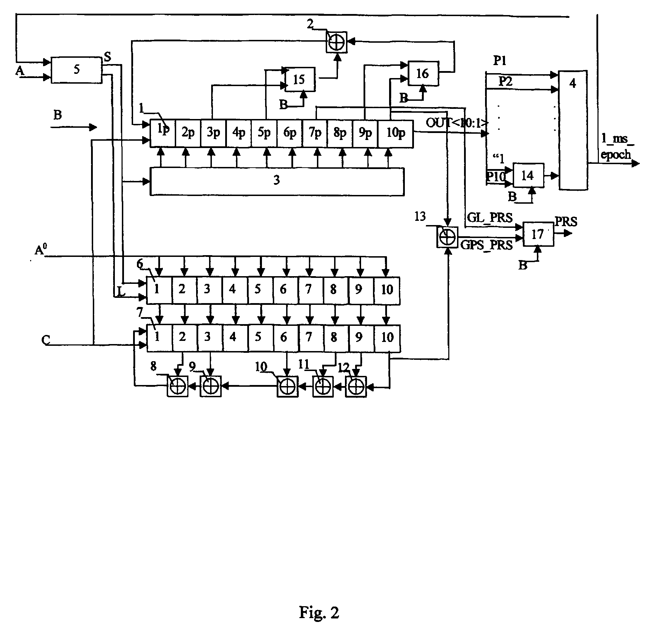

The essence of the claimed invention, a possibility of its realization and industrial applicability are explained in the drawings in Figs.1 and 2, in which:
Fig. 1 is a block diagram of the prior art generator;
Fig. 2 is a block diagram of the claimed generator.

### The preferable embodiment of the invention

The claimed PRS SRNS code generator comprises (Fig.2) a first ten-bit ("P1", "P2".., "P10") shift register 1 whose clock input is a clock input of the generator, i.e. the input of the "Code_clk" clock signals. The data input of the register 1 is connected to the output of the first modulo-two adder 2, the bit setting inputs of the register 1 are connected to the respective outputs of the device 3 for setting all "1", and the bit outputs of the register 1 are connected through a the "OUT 〈10:1〉" data bus to the inputs of the detector 4 of all "1". The output of the detector 4 of all "1", being an output of the ("1_ms_epoch") signal generator, is connected to the first input of the control unit 5 whose other input is a first control input of the generator that is the input of the "Control" signals. The first output of the control unit 5 (output of the "Set" signals) is connected to the input of the device 3 for setting all "1", as well as to the first input of the ten-bit ("P1", "P2".., "P10") initial phase register 6 whose second input is connected to the second output of the control unit 5 (output of the "Load" signals). The bit setting inputs of the initial phase register 6 are connected to the data input bus ("Initial state"), and the bit outputs are connected to the inputs for setting the corresponding bits of the second ten-bit ("P1", "P2".., "P10") shift register 7 whose clock input is connected to the clock input of the first shift register 1. The outputs of the second "P2", third "P3", sixth "P6", eighth "P8" and ninth "P9" bits of the register 7 are connected, respectively, to the first inputs of the second 8, third 9, fourth 10, fifth 11 and sixth 12 modulo-two adders, and the second input of the adder 12 is connected to the output of the tenth "P10" bit of the register 7. The outputs sixth 12, fifth 11, fourth of 10 and third 9 adders are connected, respectively, to the second inputs of the fifth 11, fourth 10, third 9 and second 8 adders while the output of the adder 8 is connected to an data input of the register 7. The outputs of the tenth bits of the shift registers 1 and 7 are connected to the inputs of the seventh modulo-two adder 13. The output of the tenth bit of the data bus "OUT 〈10:1〉", that is the output of the tenth bit of the shift register 1, is connected to the respective input of the detector 4 through the first switch 14 whose second signal input, being an input of the logical item signal ("1"), is connected to the output of an the respective signal source (not shown in Fig. 2). The outputs of the third and fifth bits of the shift register 1 are connected, respectively, to the first and second signal inputs of the second switch 15. The outputs of the tenth and ninth bits of the shift register 1 are connected, respectively, to the first and second signal inputs of the third switch 16. The outputs of switches 15 and 16 are connected to the inputs of the first modulo-two adder 2. The output of the modulo-two adder 13 and the output of the seventh bit of the first shift register 1 are connected, respectively, to the first and second signal inputs of the fourth switch 17. The control inputs of the switches 14, 15, 16, 17 are interconnected and make up a second control input of the generator, that is the input of the "Sys" signals. The output of the fourth switch 17 is an output of signals of the PRS code of the claimed generator, that is the output of "PR" signals.

All elements of the claimed PRS code generator are based on standard components of the digital technology and can be made as the components of a single large integrated circuit, i.e. the multichannel digital correlator of the receiver of the SRNS signals. For example, the control unit 5 is a pulse generator producing the "Set" and "Load" pulses shaped depending on the "1-ms_epoch" and "Control" input signals. The choice of the time diagram of shaping of "Set" and "Load" signals is determined by the working algorithm of the digital correlator having a search and tracing generator. In particular, in the tracing mode the "Set" signal is unambiguously associated with "1-ms_epoch" signal, while in the search and tuning mode the "Set" signal can be "linked" to the "1-ms_epoch" signal with an advance or lag, or to be formed from the "Control" signal. The shift register 1 can be based on triggers with inputs data, clock inputs and inputs for setting all "1". In this case, the device 3 can be made as a bus distributing the "Set" signals among the inputs for setting all "1" of the triggers of the register 1. The initial phase register 6 can be based on triggers with data inputs and clock inputs used as memory elements storing the values applied to the "Initial state" bus set by the "Load" signal through the pulse switches of the system, the data inputs of said switches receiving the control pulse "Set" and the control (switching) inputs receiving the values from the outputs of the triggers (elements of memory).

The shift register 7 can be based on triggers with data inputs, clock inputs and inputs for setting "1" and "0". In so doing the pulses for setting "1" or "0" are fed from the respective bits of the initial phase register 6 (outputs of the switches of the setup pulses) depending on the values generated on the "Initial state" bus. Thus, at the beginning of the millisecond epoch (during tracing) or during the setup of the initial value (during the search) an initial loading of the shift register 7 is formed. The detector 4 of all "1" can be built around ten "AND" circuits.

The claimed PRS code generator operates as follows.

The control unit 5 produces a signal "Set" at its first output, and this signal is fed to the input 3 of the device for setting all "1" and to the input of the initial phase register 6. At the second output the control unit 5 produces a signal "Load" which is applied to the second input of the initial phase register 6. The "Set" and "Load" signals are generated depending on the values of the millisecond epoch signals ("1_ms_epoch") fed from the output of the detector 4 of all "1" and the control signal "Control" fed from an external source according to the working algorithm. The millisecond epoch signal is formed by the detector 4 of "1" whose inputs are connected to the bit outputs of the shift register 1 by means of the switch 14 and the "OUT 〈10:1〉" data bus in such a manner that the data of the first nine bits of the register 1 act directly on the inputs of the detector 4 while the data from the tenth bit act through the switch 14. The state of the switch 14 is determined by a "Sys" signal applied to the control input of the switch from the control input of the generator. The "Sys" signal determines the current working SRNS and, respectively, the operating mode of the generator ("GPS" or "GLONASS"). In so doing in the "GPS" mode the switch 14 transfers the data from the tenth bit of the shift register 1 to its output and in the "GLONASS" mode feeds the logical item signal from the external source (not shown in Fig.2) whose operation does not depend on the tenth bit of the shift register 1. The detector 4 generates a millisecond epoch signal in the presence of all "1" at the input. This signal is used both in the PRS generator for reloading the shift registers 1 and 7, and for the readout devices of the digital correlator of the receiver of the SRNS signals, in which this generator is used. The reloading of the shift registers 1 and 7 is performed as follows. When the active "Load" signal acts on the input of the register 6, the latter is loaded with the data fed through the "Initial state" data bus. These data determine the SRNS GPS satellite whose signals are being processed (traced) in the digital correlator of the SRNS signal receiver using the signals of the given PRS code generator. When the active "Set" signal comes to the input of the device 3 for setting all "1", the ten-bit shift register 1 is reset to its initial ("1") state. When the active "Set" signal is applied to the input of the register 6 for initial phase setup, the initial state vector is loaded into the ten-bit shift register 7 from the initial phase register 6. Depending on the "Sys" signal value, determining the current working SRNS, the switches 15 and 16 apply the data either from the third and tenth bits of the shift register 1 ("GPS" mode) or from the fifth and ninth bits of the register 1 ("GLONASS" mode) to the modulo-two adder 2. The output signal of the adder 2 is applied to the data input of the register 1. Thus the PRS GLONASS code is formed, and this code is taken off the seventh bit of the register 1 in the "GLONASS" mode or the component of the PRS GPS code which is taken off the tenth bit of the register 1 at the "Code_clk" clock frequency in "GPS" mode. The "Code_clk" clock frequency applied to the clock input of the generator from the output of a respective shaper of the receiver of the SRNS signals (not shown Fig.2) corresponds to the required nominal value used in the SRNS with due account of the Doppler shift. The clock frequency acts on the clock input of the shift register 1, as well as on the clock input of the shift register 7, providing the data shift in the registers. Applied to the data input of the register 7 from the output of the modulo-two adder 8 is the signal generated as a result of the joint operation of the adders 8, 9, 10, 11, 12. The modulo-two addition made by the adders 8-12 with respect to the output signals of the second, third, sixth, eighth, ninth and tenth bits of the shift register 7 provides generation of the second part of the PRS GPS code which is taken off the output of the tenth bit of the shift register 7. The modulo-two addition of both parts of code PRS GPS code being formed from the outputs of the tenth bits of the registers 1 and 7 is made by the adder 13 forming the PRS GPS code in the "GPS' mode. The signals from the output of the adder 13 (PRS GSP code in the "GPS" mode) and the signals from the output of the seventh bit of the register 1 (RPS GLONASS code in the "GLONASS" mode) are applied, respectively, to the first and second inputs of the switch 17. The switch 17 gates through to its output either PRS GPS code ("GPS" mode) or the PRS GLONASS code ("GLONASS" mode) depending on the control "Sys" signal applied to the control input of the switch 17.

Thus the system provides operation of the PRS SRNS code generator in two modes: in the mode of shaping the PRS UPS code and in the mode of shaping the PRS GLONASS. In so doing the common elements of the generator participate in shaping the codes of both these systems thereby allowing the number of elements of the equipment to be minimized.

### Industrial applicability

From the above it is clear that the claimed invention is feasible, industrially applicable and solves the above-formulated technical problem. The invention is promising for use in the system of the integrated receivers operating on the SRNS GPS and GLONASS signals.

## Claims

1. A pseudo-random code-sequence generator for use in the satellite radio navigation systems comprising a first ten-bit shift register whose clock input is a clock input of the generator, the data input is connected to the output of a first modulo-two adder, the bit setting inputs are connected to the respective outputs of a device for setting all "1", and the bit outputs are connected to the inputs of a detector of all "1" whose output, being an output of an epoch signal generator, is connected to the first input of a control unit whose other input is a first control input of the generator, the first output of the control unit is connected to the input of the device for setting all "1", as well as to a first input of the initial phase ten-bit register whose second input is connected to the second output of the control unit, the bit setting inputs of the initial phase register are connected to the data bus while the bit outputs are connected to the inputs for setting all respective bits of the second ten-bit shift register whose clock input is connected to the clock input of the first shift register, the data input is connected to the output of a second modulo-two adder, and the outputs of the second, third, sixth, eighth and ninth bits are connected, respectively, to the first inputs of the second, third, fourth, fifth and sixth modulo-two adders, the second input of the sixth modulo-two adder being connected to the output of the tenth bit of the second ten-bit shift register; the outputs of the sixth, fifth, of the fourth and third modulo-two adders are connected, respectively, to the second inputs of the fifth, fourth, third and second modulo-two adders, the outputs of the tenth bits of the first and second shift registers being connected to the inputs of the seventh modulo-two adder, *characterized in that* the generator has first, second, third and fourth switches whose control inputs are interconnected and make up a second control input of the generator, the output of the tenth bit of the first shift register is connected to the respective input of the detector of all "1" through the first switch, whose second signal input is a logical item signal input, the outputs of the third and fifth bits of the first shift register are connected, respectively, to the first and second signal inputs of the second switch, the outputs of the tenth and ninth bits of the first shift register are connected, respectively, to the first and second signal inputs of the third switch, the outputs of the second and third switches being connected to the inputs of the first modulo-two adder; the output of the seventh modulo-two adder and the output of the seventh bit of the first shift register are connected, respectively, to the first and second signal inputs of the fourth switch whose output is a code signal output of the pseudo-random sequence of the generator.
